# EUROPEAN PATENT APPLICATION

(11) **EP 2 991 222 A1**
(43) Date of publication of application: **02.03.2016**
(21) Application number: 14788466.2
(22) Date of filing: 25.04.2014
(51) Int. Cl.: H03F 3/217

(54) **SWITCHING AMPLIFIER AND CONTROL METHOD THEREFOR**

(30) Priority: 25.04.2013 KR 20130046340
(71) Applicant: PSTEK Co. Ltd., Gyeonggi-do 431-848 (KR)
(72) Inventor: SUNG, Hwan-ho, Gunpo-si Gyeonggi-do 435-050 (KR)
(74) Representative: Thorniley, Peter
(86) International application number: PCT/KR2014/003646
(87) International publication number: WO 2014/175695

(57) **Abstract**

A fault-tolerant switching amplifier includes an inverter unit including N inverters, where N is a natural number, each of the N inverters including a plurality of switching elements and configured to perform switching ON or OFF of the switching elements based on a PWM signal inputted to the switching elements, thus switching an applied direct-current (DC) voltage, and to generate an output signal based on the switching and a switch unit including N switches respectively connected to output terminals of the N inverters, each of the N switches being configured to be short-circuited or open-circuited based on whether or not the corresponding one of the N inverters is in a normal operation condition. The output terminals of the N inverters are connected in series, such that output signals outputted from the inverters are combined to generate an amplified signal.

## Description

### [Technical Field]

The present disclosure relates to a switching amplifier and a control method therefor.

### [Background]

The statements in this section merely provide background information related to the present disclosure and do not necessarily constitute prior art.

An amplifier is a device that receives a small signal and amplifies it to a large signal. An example of the amplifier that is a common sight in everyday life includes an acoustic amplifier that is called an audio amplifier. Most amplifiers have a scheme of linear amplifier which generates an amplified signal of an input signal by switching on or off a transistor. The linear amplifier has an advantage of broad output bandwidth and low noise; however, there is a disadvantage that, when an output voltage is lower than an input voltage, the efficiency is considerably degraded due to a loss of a semiconductor device.

One of the methods for improving the disadvantage of the linear amplifier is a switching amplifier. Unlike the linear amplifier, the switching amplifier causes the semiconductor device such as a transistor to operate in either of ON state and OFF state, and generates a rectangular wave having the maximum and the minimum of the input voltage depending on the operating state of the semiconductor device. The switching amplifier outputs the rectangular wave with reduced high-frequency component by using a low pass filter. The switching amplifier has an advantage that the efficiency is greatly improved compared to the linear amplifier as a voltage lower than the input voltage is applied to the semiconductor device when the semiconductor device operates in the ON state to flow a current. However, the switching amplifier has a disadvantage that there is a limit in achieving a sufficiently broad bandwidth as it performs the switching with a frequency sufficiently higher than the output bandwidth and that the noise is relatively high as the rectangular wave is generated from a voltage and a current flowing into a switching element according to the switching.

On the other hand, both the linear amplifier and the switching amplifier have a reliability issue that, when they are malfunctional, the input signal cannot be amplified until the amplifiers are recovered from the fault condition.

### [Disclosure]

### [Technical Problem]

Therefore, the present disclosure has been made in view of the above aspects, and it is an object of the present disclosure to increase reliability of the switching amplifier by using a fault-tolerant switching amplifier having a scheme in which a plurality of inverters driven by an insulated power source and connected in series and a plurality of switches connected to output terminals of the inverters, respectively, and short-circuited or open-circuited depending on whether or not the corresponding one of the inverters is in a normal operation condition, such that even when one or more inverters are malfunctioning, the rest of the inverters enable the switching amplifier to perform a normal operation.

Further, it is another object of the present disclosure to amplify a signal with minimized conduction loss and switching loss, which are accompanied by an operation of a switching element, while achieving an amplified signal with high efficiency and low noise by using a hybrid switching amplifier employing an inverter including a switching element with high withstand voltage and low switching speed and a switching element with low withstand voltage and high switching speed.

### [Summary]

A fault-tolerant switching amplifier, according to some embodiments of the present disclosure, includes an inverter unit including N inverters, where N is a natural number, each of the N inverters including a plurality of switching elements and configured to perform switching ON or OFF of the switching elements based on a PWM signal inputted to the switching elements, thus switching an applied direct-current (DC) voltage, and to generate an output signal based on the switching and a switch unit including N switches respectively connected to output terminals of the N inverters, each of the N switches being configured to be short-circuited or open-circuited based on whether or not the corresponding one of the N inverters is in a normal operation condition. The output terminals of the N inverters are connected in series, such that output signals outputted from the inverters are combined to generate an amplified signal.

A hybrid switching amplifier, according to some embodiments of the present disclosure, includes an inverter unit including N-1 inverters, where N is a natural number larger than 1, each of the N-1 inverters including a plurality of first switching elements and M inverters, where M is a natural number, each of the M inverters including a plurality of second switching elements having electrical characteristics different from those of the N-1 inverters, the N-1 inverters and the M inverters being configured to perform switching ON or OFF of the first switching elements and the second switching elements, respectively, based on a PWM signal inputted to the first switching elements and the second switching elements, thus switching an applied direct-current (DC) voltage, and to generate an output signal based on the switching and a switch unit including N-1 switches and M switches respectively connected to output terminals of the N-1 inverters and the M inverters, each of the N-1 switches and the M switches being configured to be short-circuited or open-circuited based on whether or not the corresponding one of the N-1 inverters and M inverters is in a normal operation condition. The output terminals of the N-1 inverters and the M inverters are connected in series, such that output signals outputted from the inverters are combined to generate an amplified signal.

A method performed by a fault-tolerant switching amplifier for generating a PWM signal for controlling operations of N inverters, according to some embodiments of the present disclosure, includes calculating number of inverters to be additionally switched ON or OFF at a starting point of each switching cycle based on an input signal and a result of a feedback control of an amplified signal of the input signal, generating, when an inverter is to be additionally switched ON from a result of the calculating, the PWM signal that allows an inverter in a predetermined order to be additionally switched ON, generating, when an inverter is to be additionally switched OFF from a result of the calculating, the PWM signal that allows an inverter in a predetermined order among inverters in ON state to be additionally switched OFF, and generating, when an inverter is to be additionally switched OFF with a duty ratio from a result of the calculating, the PWM signal that allows an inverter in a predetermined order among inverters in ON state to be additionally switched OFF with the duty ratio.

A method performed by a hybrid switching amplifier for generating a PWM signal for controlling operations of N-1 inverters and M converters, according to some embodiments of the present disclosure, includes calculating the number of inverters from the N-1 inverters and the number of inverters from the M inverters to be to be additionally switched ON or OFF at a starting point of each switching cycle based on an input signal and a result of a feedback control of an amplified signal of the input signal, generating, when at least one inverter is to be additionally switched ON from the N-1 inverters and the M inverters from a result of the calculating, the PWM signal that allows at least one inverter in a preset order among the respective N-1 inverters and M inverters to be additionally switched ON, generating, when at least one inverter in ON state is to be additionally switched OFF from the N-1 inverters and the M inverters from a result of the calculating, the PWM signal that allows the inverters in a preset order among the respective N-1 inverters and M inverters to be additionally switched OFF, and generating, when at least one inverter in ON state is to be additionally switched OFF with a duty ratio from the N-1 inverters and the M inverters from a result of the calculating, the PWM signal that allows the inverters in a preset order among the respective N-1 inverters and M inverters to be additionally switched OFF with the duty ratio.

### [Advantageous Effects]

According to some embodiments of the present disclosure, the reliability of the switching amplifier can be increased by using a fault-tolerant switching amplifier having a scheme in which a plurality of inverters driven by an insulated power source and connected in series and a plurality of switches connected to output terminals of the inverters, respectively, and short-circuited or open-circuited depending on whether or not the corresponding one of the inverters is in a normal operation condition, such that even when one or more inverters are malfunctioning, the rest of the inverters enable the switching amplifier to perform a normal operation.

Further, according to some embodiments of the present disclosure, the efficiency of the signal amplification can be increased by minimizing conduction loss and switching loss, which are accompanied by an operation of a switching element, while achieving an amplified signal with high efficiency and low noise by using a hybrid switching amplifier employing an inverter including a switching element with high withstand voltage and low switching speed and a switching element with low withstand voltage and high switching speed.

### [Brief Description of Drawings]

FIG. 1 is a schematic circuit diagram of a fault-tolerant switching amplifier according to some embodiments of the present disclosure.
FIG. 2 is a schematic circuit diagram of a hybrid switching amplifier according to some embodiments of the present disclosure.
FIG. 3 is a diagram for illustrating a process of controlling operations of N inverters based on a PWM signal by the fault-tolerant switching amplifier according to some embodiments of the present disclosure.
FIG. 4 is a diagram for illustrating a process of controlling operations of N-1 inverters and M inverters based on a PWM signal by a hybrid switching amplifier according to some embodiments of the present disclosure.
FIG. 5 is a flowchart of a method of generating the PWM signal for controlling the operations of the N inverters by the fault-tolerant switching amplifier according to some embodiments of the present disclosure.
FIG. 6 is a flowchart of a method of generating the PWM signal for controlling the operations of the N-1 inverters and the M inverters by the hybrid switching amplifier according to some embodiments of the present disclosure.

### [Detailed Description]

Hereinafter, at least one embodiment of the present disclosure will be described in detail with reference to the accompanying drawings.

In the following description, like reference numerals designate like elements although the elements are shown in different drawings. Further, in the following description of the at least one embodiment, a detailed description of known functions and configurations incorporated herein will be omitted for the purpose of clarity and for brevity.

Additionally, various terms such as first, second, A, B, (a), (b), etc., are used solely for the purpose of differentiating one component from the other but not to imply or suggest the substances, order or sequence of the components. If a component were described as 'connected', 'coupled', or 'linked' to another component, they may mean the components are not only directly 'connected', 'coupled', or 'linked' but also are indirectly 'connected', 'coupled', or 'linked' via one or more additional components.

A switching amplifier includes an inverter including a plurality of switching elements. The switching amplifier generates an amplified signal of an input signal by switching an applied direct-current (DC) voltage by ON or OFF controlling the switching elements based on a PWM signal inputted to each of the switching elements. Afault-tolerant switching amplifier 100 according to some embodiments of the present disclosure is configured to increase the reliability of the switching amplifier by, even when one or more inverters are malfunctioning, causing the rest of the inverters to enable the switching amplifier to perform a normal operation. Further, the hybrid switching amplifier 200 according to some embodiments of the present disclosure is configured to increase the efficiency of the signal amplification by minimizing conduction loss and switching loss, which are accompanied by an operation of a switching element, while achieving an amplified signal with high efficiency and low noise.

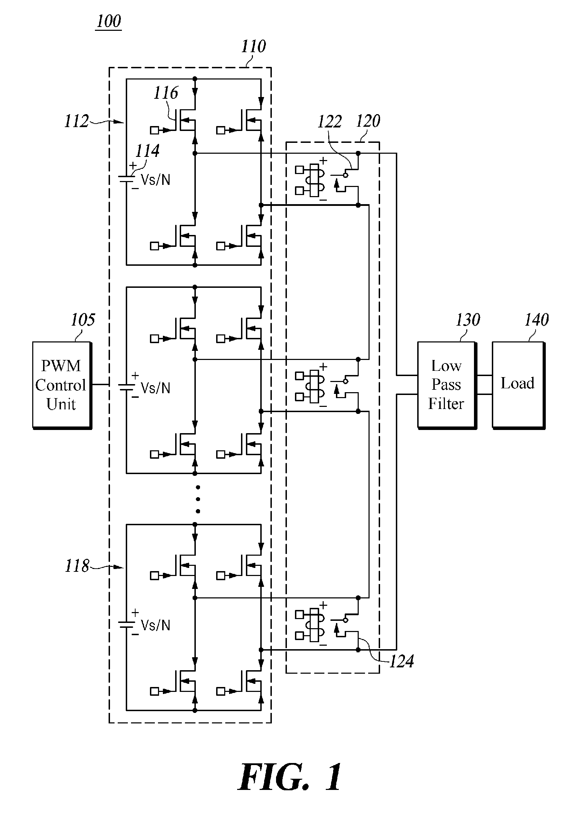

FIG. 1 is a schematic circuit diagram of the fault-tolerant switching amplifier 100 according to some embodiments of the present disclosure.

As shown in FIG. 1, the fault-tolerant switching amplifier 100 according to some embodiments of the present disclosure includes an inverter unit 110 including the N inverters (first inverter 112 to N-th inverter 118), a switch unit 120 including the N switches (first switch 122 to N-th switch 124), a low pass filter 130, and a load 140.

The fault-tolerant switching amplifier 100 according to some embodiments of the present disclosure includes N inverters 112 to 118 including a plurality of switching elements having low withstand voltage and high switching speed, by which the switching loss accompanied by the amplification of the input signal can be minimized. Further, the fault-tolerant switching amplifier 100 can reduce the withstand voltage and the switching voltage of the switching elements by employing a serial connection of the N inverters 112 to 118, by which the noise of the amplified signal can be reduced. Moreover, the fault-tolerant switching amplifier 100 includes N switches respectively connected to output terminals of the inverters connected in series and short-circuited or open-circuited depending on whether or not the corresponding one of the inverters is in a normal operation condition. With this configuration, even when one or more inverters among the N inverters 112 to 118 are malfunctioning, the fault-tolerant switching amplifier 100 is configured to perform a normal operation with the rest of the inverters.

The fault-tolerant switching amplifier 100 according to some embodiments of the present disclosure further includes a PWM control unit 105. The PWM control unit 105 receives an input signal and generates a PWM signal for determining a duty ratio depending on a result of a feedback control of the input signal. That is, the PWM control unit 105 determines an output voltage required to amplify the input signal to a predetermined amplification level based on the received input signal in each cycle, and generates the PWM signal for determining the duty ratio that allows the N inverters 112 to 118 to generate the required output voltage in each cycle.

The PWM control unit 105 according to some embodiments of the present disclosure determines an entire output voltage to be outputted from the N inverters 112 to 118 at a starting point of each switching cycle based on the input signal and a result of a feedback control of the amplified signal. The PWM control unit 105 calculates the number of inverters to be additionally switched ON or OFF among the N inverters 112 to 118 based on the determined output voltage. When at least one inverter is to be additionally switched ON or OFF among the N inverters 112 to 118, the PWM control unit 105 generates the PWM signal in a manner that the N inverters 112 to 118 are switched ON or OFF in a predetermined order of the inverters.

That is, when at least one inverter is to be additionally switched ON among the N inverters 112 to 118 based on the input signal, the PWM control unit 105 generates the PWM signal that allows an inverter in the predetermined order to be switched ON. When an inverter in ON state is to be switched OFF based on the input signal, the PWM control unit 105 generates the PWM signal that allows an inverter in the predetermined order among inverters in ON state to be switched OFF. When an inverter in ON state is to be switched OFF with a predetermined duty ratio based on the input signal, the PWM control unit 105 generates the PWM signal that allows an inverter in the predetermined order among inverters in ON state to be switched OFF with the predetermined duty ratio.

For example, when at least one inverter among the N inverters 112 to 118 is to be additionally switched ON based on the input signal, the PWM control unit 105 generates the PWM signal that allows the inverters to be additionally switched ON starting from an inverter having the highest order in the predetermined order. When an inverter in ON state is to be switched OFF based on the input signal, the PWM control unit 105 generates the PWM signal that allows the inverters to be switched OFF starting from an inverter having the lowest order in predetermined order among the inverters in ON state. When an inverter in ON state is to be switched OFF with the predetermined duty ratio based on the input signal, the PWM control unit 105 generates the PWM signal that allows the inverters to be switched OFF with the predetermined duty ratio starting from an inverter having the lowest order in predetermined order among the inverters in ON state.

A switching frequency applied to each of the N inverters 112 to 118 included in the fault-tolerant switching amplifier 100 according to some embodiments of the present disclosure is reduced by a predetermined magnitude compared to that applied to an inverter of a switching amplifier that includes a single inverter.

If the dynamic range of an output voltage required in each switching cycle is not large, the PWM control unit 105 generates the PWM signal that allows an inverter in OFF state to be switched ON and an inverter in ON state to be switched OFF in each switching cycle. In this case, the switching frequency applied to each of the N inverters 112 to 118 is reduced to 1/N of the switching frequency applied to an inverter of a switching amplifier including a single inverter. That is, the fault-tolerant switching amplifier 100 according to some embodiments of the present disclosure constitutes the switching amplifier with the N inverters 112 to 118 including a plurality of switching elements having low withstand voltage and high switching speed, and reduces an equivalent switching frequency of each inverter, thus minimizing the switching loss accompanied by the operation of the switching element in the process of amplifying the input signal.

The preset order of inverter operations among the N inverters 112 to 118 according to some embodiments of the present disclosure is not limited to a particular scheme, but the order can be determined by way of various schemes.

The inverter unit 110 N includes the N inverters (first inverter 112 to N-th inverter 118), where N is a natural number. Each of the N inverters 112 to 118 includes a plurality of switching elements 116. The inverter unit 110 generates an output signal by switching an applied DC voltage by ON or OFF controlling the switching elements 116 based on the PWM signal inputted to the switching elements 116. Each of the N inverters 112 to 118 includes a DC power source 114 that supplies a DC voltage. Allowing the DC voltage of Vs/N obtained by dividing Vs (an output voltage required for a predetermined amplification level) by the number of inverters to be applied to each DC power source 114, the inverter unit 110 can control the inverters in the simplest manner. If other voltage is applied, a more complicated calculation is needed.

The inverter unit 110 of the fault-tolerant switching amplifier 100 shown in FIG. 1 includes the N inverters 112 to 118 implemented in a MOSFET form.

In this case, a switching element having low withstand voltage and relatively high switching speed is used for the switching elements 116 included in the N inverters 112 to 118, in order to reduce the switching loss rather than the conduction loss between those two losses incidental to the operations of the switching elements 116.

The losses generated in the switching amplifier are classified into a conduction loss generated from a current flowing in a conduction state (ON state) and a switching loss generated from every switching operation. The conduction loss increases as more current flows and as a voltage drop increases when the current flows into the switching element. The switching loss increases as a switching energy generated every time the switching element performs the switching operation and as the switching frequency increases. When the current flows, the MOSFET exhibits characteristics like a resistor. That is, if a plurality of switching elements constituting the MOSFET is connected in parallel to reduce the resistance, the conduction loss can be reduced as needed. The fault-tolerant switching amplifier 100 according to some embodiments of the present disclosure implements the N inverters 112 to 118 in the MOSFET form to reduce the conduction loss, and employs a switching element having low withstand voltage and high switching speed as the plurality of switching elements included in the N inverters 112 to 118 to reduce the switching loss rather than the conduction loss, thus minimizing the switching loss.

The inverter unit 110 according to some embodiments of the present disclosure includes inverters of at least one more than the number of inverters for providing the output voltage required for a predetermined maximum amplification level. With this configuration, when at least one inverter is malfunctioning among the N inverters 112 to 118, the required output voltage can be supplied from the rest of the inverters by short-circuiting the switch connected to the output terminal of the malfunctional inverter.

Even when any one of the N inverters 112 to 118 is malfunctioning among the N inverters 112 to 118, the N inverters 112 to 118 according to some embodiments of the present disclosure are configured such that the rest of the inverters except for the malfunctional inverter continue to operate. Further, the malfunctional inverter can be fixed or replaced with a new inverter while the rest of the inverters are operating and the corresponding inverter after fixing or replacing can resume the operation. The fault-tolerant switching amplifier 100 according to some embodiments of the present disclosure can continuously operate regardless of the malfunctioning of the inverter, by which the reliability of the switching amplifier can be improved.

Although it is described that, in FIG. 1, the inverter unit 110 includes the N inverters 112 to 118 implemented in the MOSFET form and a switching element having low withstand voltage and relatively high switching speed is used for the switching elements 116 included in the N inverters 112 to 118, the present disclosure is not limited to this scheme, but various types of inverter and a plurality of switching elements having various electrical characteristics can be used.

The switch unit 120 includes the N switches (first switch 122 to N-th switch 124 connected to the output terminals of the N inverters 112 to 118 in parallel and short-circuited or open-circuited depending on whether the corresponding one of the N inverters 112 to 118 is in a normal operation condition. Each of the N switches 122 to 124 is open-circuited when it is determined that the inverter connected to each switch is in the normal operation condition, and short-circuited when it is determined that the inverter connected to each switch is malfunctioning, such that the malfunctional inverter does not affect the operations of the rest of the inverters. In some embodiments, the fault-tolerant switching amplifier 100 further includes a switch-operation control unit (not shown) that determines whether or not the N inverters 112 to 118 are in the normal operation condition, and generates a control command to allow the N inverters 112 to 118 to be short-circuited or open-circuited based on the determination made.

The output terminals of the N inverters 112 and 118 are connected in series, to generate an amplified signal by combining the output signals respectively outputted from the inverters. The amplified signal generated from the output terminals of the N inverters 112 to 118 passes through the low pass filter 130 to block a high frequency component, such that a finally required frequency component is only supplied to the load 140.

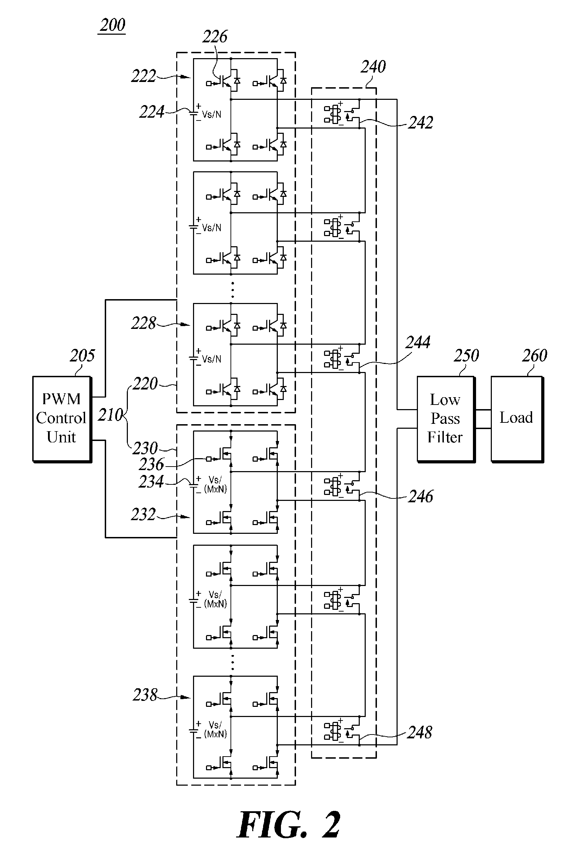

FIG. 2 is a schematic circuit diagram of a hybrid switching amplifier 200 according to some embodiments of the present disclosure.

As shown in FIG. 2, the hybrid switching amplifier 200 according to some embodiments of the present disclosure includes an inverter unit 210 including a first inverter group 220 and a second inverter group 230, a switch unit 240 including N-1 switches (first switch 242 to (N-1)-th switch 244) and M switches (first switch 246 to M-th switch 248), a low pass filter 250, and a load 260. The first inverter group 220 includes N-1 inverters (first inverter 222 to (N-1)-th inverter 228), where N is a natural number larger than 1, and the second inverter group 230 includes M inverters (first inverter 232 to M-th inverter 238).

The hybrid switching amplifier 200 according to some embodiments of the present disclosure includes the N-1 inverters 222 to 228 including a plurality of switching elements 226 having high withstand voltage and relatively high switching loss and the M inverters 232 to 238 including a plurality of switching elements 236 having low withstand voltage and relatively low switching loss compared to the switching elements 226 included n the N inverters 112 to 118, thus operating with low conduction loss and low switching loss even at high switching frequency.

The hybrid switching amplifier 200 according to some embodiments of the present disclosure further includes a PWM control unit 205. The PWM control unit 205 receives an input signal and generates a PWM signal for determining a duty ratio depending on a result of a feedback control of the input signal. The PWM control unit 205 determines an output voltage required to amplify the input signal to a predetermined amplification level based on the received input signal in each cycle, and generates the PWM signal for determining the duty ratio that allows the N-1 inverters 222 to 228 and the M inverters 232 to 238 to generate the required output voltage in each cycle.

The PWM control unit 205 according to some embodiments of the present disclosure generates the PWM signal that allows the switching frequency of the N-1 inverters 222 to 228 to be lower than the switching frequency of the M inverters 232 to 238 based on the input signal and the result of the feedback control of the amplified signal. That is, the PWM control unit causes the N-1 inverters 222 to 228 to supply most output voltage required to amplify the input signal while performing the switching operation at a low switching frequency by controlling the switching frequencies of the N-1 inverters 222 to 228 and the M inverters 232 to 238. Further, the PWM control unit 205 causes the M inverters 232 to 238 to supply the rest of the output voltage while performing the switching at a high switching frequency by controlling the switching frequencies of the N-1 inverters 222 to 228 and the M inverters 232 to 238.

The inverter structures of the N-1 inverters 222 to 228 and the M inverters 232 to 238 for the N-1 inverters 222 to 228 to supply most of the output voltage required to amplify the input signal and for the M inverters 232 to 238 to supply the rest of the output voltage will be additionally described in the description of the inverter unit 210.

The PWM control unit 205 determines an output voltage to be outputted from the N-1 inverters 222 to 228 and the M inverters 232 to 238 at a starting point of each switching cycle based on the input signal and the result of the feedback control on the amplified signal. The PWM control unit 205 calculates the number of inverters to be additionally switched ON or OFF among the N-1 inverters 222 to 228 and the M inverters 232 to 238 based on the determined output voltage. Thereafter, when any one of the N-1 inverters 222 to 228 and the M inverters 232 to 238 is to be additionally switched ON or OFF, the PWM control unit 205 generates the PWM signal that allows the N-1 inverters 222 to 228 and the M inverters 232 to 238 to be switched ON or OFF in their preset order.

When at least one inverter is to be additionally switched ON among the N-1 inverters 222 to 228 and the M inverters 232 to 238 based on the input signal, the PWM control unit 205 generates the PWM signal that allows the inverters in a preset order among the respective N-1 inverters 222 to 228 and M inverters 232 to 238 to be additionally switched ON. When an inverter in ON state is to be switched OFF based on the input signal, the PWM control unit 205 generates the PWM signal that allows the inverters to be switched OFF from an inverter in the predetermined order among inverters in ON state. When an inverter in ON state is to be switched OFF with a predetermined duty ratio, the PWM control unit 205 generates the PWM signal that allows an inverter in the predetermined order among inverters in ON state to be switched OFF with the predetermined duty ratio.

For example, when at least one inverter is to be additionally switched ON among the N-1 inverters 222 to 228 and the M inverters 232 to 238 based on the input signal, the PWM control unit 205 generates the PWM signal that allows the inverters to be additionally switched ON starting from an inverter having the highest order in a preset order among the respective N-1 inverters 222 to 228 and M inverters 232 to 238. When an inverter in ON state is to be switched OFF based on the input signal, the PWM control unit 205 generates the PWM signal that allows the inverters to be switched OFF starting from an inverter having the lowest order among inverters in ON state. When an inverter in ON state is to be switched OFF with a predetermined duty ratio based on the input signal, the PWM control unit 205 generates the PWM signal that allows an inverter having the lowest order among inverters in ON state to be switched OFF with the predetermined duty ratio.

With this configuration, in the similar manner to the above-described fault-tolerant switching amplifier 100, the hybrid switching amplifier 200 according to some embodiments of the present disclosure is configured to reduce the switching frequency of each of the N-1 inverters 222 to 228 and the M inverters 232 to 238. Further, when a change of an output voltage required in each switching cycle is not large, the hybrid switching amplifier 200 is configured to fully reduce the switching frequency of the N-1 inverters 222 to 228 and the M inverters 232 to 238, to generate the amplified signal with relatively high efficiency and low noise.

The preset order of inverter operations among the N-1 inverters 222 to 228 and the M inverters 232 to 238 according to some embodiments of the present disclosure is not limited to a particular scheme, but the order can be determined by way of various schemes.

The inverter unit 210 includes the N-1 inverters (first inverter 222 to (N-1)-th inverter 228) each including a plurality of switching elements 226 and the M inverters (first inverter 232 to M-th inverter 238) each including a plurality of switching elements 236 having different electrical characteristics from the switching elements 226 included in the N-1 inverters 222 to 228. The N-1 inverters 222 to 228 and the M inverters 232 to 238 generate the output signal by switching an applied DC voltage by ON or OFF controlling the switching elements based on the PWM signal inputted to the switching elements. Each of the N-1 inverters 222 to 228 and the M inverters 232 to 238 includes a DC power source 224, 234 that supplies a DC voltage.

The inverter unit 210 of the hybrid switching amplifier 200 according to some embodiments of the present disclosure causes the entire output voltage of the N-1 inverters 222 to 228 each capable of generating an output voltage of Vs/N to generate the output voltage of Vs(N-1)/N when Vs (an output voltage required for a predetermined amplification level) is equally divided by N (the number of inverters). Further, the inverter unit 210 causes the entire output voltage of the M inverters 232 to 238 each capable of generating an output voltage of Vs/(N x M) to generate the output voltage of Vs/N. Consequently, the N-1 inverters 222 to 228 and the M inverters 232 to 238 are configured to generate the output voltage up to Vs. With this configuration, the PWM control unit 205 generates the PWM signal that allows the N-1 inverters 222 to 228 to supply most output voltage required to amplify the input signal while switching at a low switching frequency and the M inverters 232 to 238 to supply the rest of the output voltage while switching at a high switching frequency by controlling the switching frequencies of the N-1 inverters 222 to 228 and the M inverters 232 to 238.

The inverter unit 210 of the hybrid switching amplifier 200 according to some embodiments of the present disclosure shown in FIG. 2 includes the N-1 inverters 222 to 228 implemented in the IGBT form and the M inverters 232 to 238 implemented in the MOSFET form. As described with reference to the fault-tolerant switching amplifier 100 shown in FIG. 1, in the case of an inverter implemented in the MOSFET form, the resistance can be reduced by way of a parallel connection of the switching elements constituting the MOSFET and the conduction loss can be reduced as needed. In the case of an inverter implemented in the IGBT form, it can be efficiently used for high voltage, and as the voltage drop when the current flows into the switching element is smaller than that of the MOSFET, the conduction loss can be reduced (for when the withstand voltage is the same, the current per unit area of the semiconductor device is large). That is, the hybrid switching amplifier 200 according to some embodiments of the present disclosure operates with low conduction loss by employing the N-1 inverters 222 to 228 implemented in the IGBT form and the M inverters 232 to 238 implemented in the MOSFET form.

Although it is described that, in the hybrid switching amplifier 200 according to some embodiments of the present disclosure, the N-1 inverters 222 to 228 is implemented in the IGBT form and the M inverters 232 to 238 is implemented in the MOSFET form, the present disclosure is not limited to this scheme, but any form can be uses so long as a plurality of elements having different characteristics from each other is used. For example, the IGBT can be substituted with a MOSFET having the same withstand voltage.

The switching elements 226 included in the N-1 inverters 222 to 228 implemented in the IGBT form are selected for having higher withstand voltage and higher switching loss relative to the switching elements 236 included in the M inverters 232 to 238 implemented in the MOSFET form. Further, the switching elements 236 included in the M inverters 232 to 238 implemented in the MOSFET form are selected for having lower withstand voltage and lower switching loss relative to the switching elements 226 included n the N-1 inverters 222 to 228 implemented in the IGBT form. That is, the hybrid switching amplifier 200 includes inverters respectively including switching elements having different electrical characteristics from each other, and hence the conductor loss is low and the switching loss is low even at a high switching frequency.

The switching elements 226 included in the N-1 inverters 222 to 228 implemented in the IGBT form are described in comparison with the switching elements 236 included in the M inverters 232 to 238 implemented in the MOSFET form as having higher withstand voltage and higher switching loss, although the present disclosure is not limited to this scheme, but the switching elements 226 having high withstand voltage and high switching loss compared to most switching elements can also be used.

Likewise, the switching elements 236 included in the M inverters 232 to 238 implemented in the MOSFET form are described in comparison with the switching elements 226 included n the N-1 inverters 222 to 228 implemented in the IGBT form, although the present disclosure is not limited to this scheme, but the switching elements 236 having low withstand voltage and low switching loss compared to most switching elements can also be used.

The inverter unit 210 according to some embodiments of the present disclosure includes inverters of at least one more than the number of inverters for providing the output voltage required for a predetermined maximum amplification level in the N-1 inverters 222 to 228 and the M inverters 232 to 238. With this configuration, when at least one inverter is malfunctioning among the N-1 inverters 222 to 228 and the M inverters 232 to 238, the required output voltage can be supplied from the rest of the inverters by short-circuiting the switch connected to the output terminal of the malfunctional inverter.

The switch unit 240 includes the N-1 switches (first switch 242 to (N-1)-th switch 244) and the M switches (first switch 246 to M-th switch 248) respectively connected to the output terminals of the N-1 inverters 222 to 228 and the M inverters 232 to 238 in parallel and short-circuited or open-circuited depending on whether or not the corresponding one of the N-1 inverters 222 to 228 and the M inverters 232 to 238 is in a normal operation condition. Each of the N-1 switches 242 to 244 and the N switches 246 to 248 is open-circuited when it is determined that the inverter connected to each switch is in the normal operation condition, and short-circuited when it is determined that the inverter connected to each switch is malfunctioning, such that the malfunctional inverter does not affect the operations of the rest of the inverters. In some embodiments, the hybrid switching amplifier 200 further includes a switch-operation control unit (not shown) that determines whether or not the N-1 inverters 222 to 228 and the M inverters 232 to 238 are in the normal operation condition, and generates a control command to allow the N-1 inverters 222 to 228 and the M inverters 232 to 238 to be short-circuited or open-circuited based on a result of the determination.

The output terminals of the N-1 inverters 222 to 228 and the M inverters 232 to 238 are connected in series, to generate an amplified signal by combining the output signals respectively outputted from the inverters. The amplified signal generated from the output terminals of the N inverters 112 to 118 passes through the low pass filter 250 to block a high frequency component, such that only the required frequency component is finally supplied to the load 260.

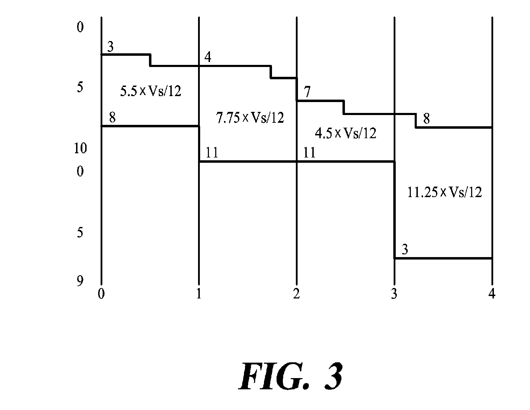

FIG. 3 is a schematic diagram for illustrating a process of controlling operations of the N inverters 112 to 118 based on a PWM signal by the fault-tolerant switching amplifier 100 according to some embodiments of the present disclosure. In FIG. 3, it is assumed that the fault-tolerant switching amplifier 100 includes a total of twelve inverters 112 to 118, and the order is assigned to each inverter from 1 to 12.

Although a process is instantiated in FIG. 3 that at least one inverter among the N inverters 112 to 118 is additionally switched ON of OFF in the operation order shown in FIG. 1, the present disclosure is not limited to this scheme, but at least one inverter among the N inverters 112 to 118 can be switched ON or OFF in various operations orders.

When it is assumed that the maximum output voltage that can be generated by each of the twelve inverters 112 to 118 is Vs/12 and the entire output voltage of 5.50xVs/12 is to be generated in the first cycle based on the input signal and the result of the feedback control of the amplified signal, the fault-tolerant switching amplifier 100 operates in a manner that five inverters are switched ON with the duty ratio of 100% and one inverter is switched ON with the duty ration of 50% for one switching cycle. That is, the fault-tolerant switching amplifier 100 operates the third to eighth inverters to be switched ON among the twelve inverters 112 to 118 based on the PWM signal in the first cycle and the third inverter having the lowest order in the operation order to be switched OFF with the duty ratio of 50%, thus generating the entire output voltage of 5.50xVs/12 for one cycle. Although it is described that, in FIG. 3, the first-operating inverter is the third inverter, it is a mere example for describing the process of controlling the 12 inverters 112 to 118 based on the PWM signal by the fault-tolerant switching amplifier 100, and the present disclosure is not limited to this scheme.

Thereafter, it is assumed that the fault-tolerant switching amplifier 100 generates the entire output voltage of 7.75xVs/12 in the second cycle based on the input signal and the result of the feedback control of the amplified signal. At this time, as the five inverters have been switched ON in the last cycle and eight inverters are supposed to be switched ON in the next cycle, the fault-tolerant switching amplifier 100 operates in a manner that three inverters in the next orders in the operation order are additionally switched ON and an inverter having the lowest order among the inverters in ON state is switched OFF with the duty ration of 75% based on the PWM signal. That is, with the fourth to eighth inverters maintaining ON state in the last cycle, the fault-tolerant switching amplifier 100 operates the ninth to eleventh inverters to be switched ON and the fourth inverter having the lowest order among the fourth to eleventh inverters in ON state to be switched OFF with the duty ratio of 75%.

Thereafter, it is assumed that the fault-tolerant switching amplifier 100 generates the entire output voltage of 4.50×Vs/12 in the third cycle based on the input signal and the result of the feedback control of the amplified signal. A total of five inverters are then supposed to be switched ON in the next cycle. As the seven inverters of the fifth to eleventh inverters have been in ON state at the end of the last cycle, the fault-tolerant switching amplifier 100 operates two inverters having the lowest and the second lowest orders among the inverters in ON state to be switched OFF and operates an inverter having the lowest order among the rest of the inverters in ON state to be switched OFF with the duty ratio of 50%. That is, the fifth and sixth inverters are switched OFF and the seventh inverter having the lowest order among the rest of the inverters in ON state, i.e., the seventh to eleventh inverters, is switched OFF with the duty ratio of 50%.

Thereafter, it is assumed that the fault-tolerant switching amplifier 100 generates the entire output voltage of 11.25xVs/N in the fourth cycle based on the input signal and the result of the feedback control of the amplified signal. The fault-tolerant switching amplifier 100 then operates twelve inverters to be switched ON at the start of the switching cycle. As the eighth to eleventh inverters have been in ON state in the last cycle, the fault-tolerant switching amplifier 100 further operates the next eight inverters in their order to be additionally switched ON and operates an inverter having the lowest order among the inverters in ON state to be switched OFF with the duty ratio of 25%.

The fault-tolerant switching amplifier 100 according to some embodiments of the present disclosure receives the PWM signal via the PWM control unit 105 and controls the operations of the N inverters. The PWM control unit 105 determines the entire output voltage to be outputted from the N inverters 112 to 118 at the starting point of each switching cycle based on the input signal and the result of the feedback control of the amplified signal. The PWM control unit 105 calculates the number of inverters to be additionally switched ON or OFF among the first to N-th inverters 112 to 118 based on the determined output voltage. Thereafter, when at least one inverter is to be additionally switched ON among the N inverters 112 to 118, the PWM control unit 105 generates the PWM signal that allows the inverters to be additionally switched ON starting from an inverter having the highest order in the predetermined operation order. When at least one inverter is to be switched OFF among the N inverters 112 to 118, the PWM control unit 105 generates the PWM signal that allows the inverters to be switched OFF starting from an inverter having the lowest order. When at least one inverter is to be switched OFF with a predetermined duty ratio among the N inverters 112 to 118, the PWM control unit 105 generates the PWM signal that allows the inverters to be switched OFF with the predetermined duty ratio starting from an inverter having the lowest order. With this configuration, the switching frequency applied to each of the first to N-th inverters 112 to 118 is reduced to 1/N of the switching frequency applied to an inverter of a switching amplifier including a single inverter, and as the switching voltage is reduced to 1/N, the switching loss is also reduced to a value smaller than a factor of 1/N.

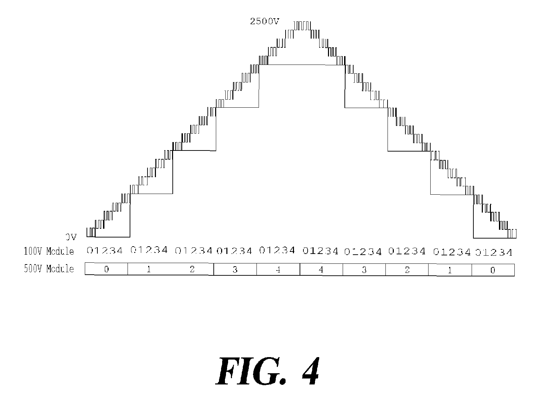

FIG. 4 is a schematic diagram for illustrating a process of controlling operations of the N-1 inverters 222 to 228 and the M inverters 232 to 238 based on a PWM signal by the hybrid switching amplifier 200 according to some embodiments of the present disclosure. When it is assumed that the hybrid switching amplifier 200 according to some embodiments of the present disclosure is configured to generate the maximum output voltage of 2500Vs, each of the N-1 inverters 222 to 228 is configured to generate the maximum output voltage of 500Vs, and each of the M inverters 232 to 238 is configured to generate the maximum output voltage of 100Vs, the N-1 inverters 222 to 228 are constituted with a total of four inverters and the M inverters 232 to 238 are constituted with a total of five inverters. In this case, the N-1 inverters 222 to 228 and the M inverters 232 to 238 are assigned with orders of 1 to 4 and 1 to 5, respectively.

Although it is instantiated in FIG. 4 that at least one inverter among the N-1 inverters 222 to 228 and the M inverters 232 to 238 is additionally switched ON of OFF in the operation order shown in FIG. 2, the present disclosure is not limited to this scheme, but at least one inverter among the N-1 inverters 222 to 228 and the M inverters 232 to 238 can be switched ON or OFF in various operations orders.

In FIG. 4, it is assumed that the output voltage is increased from the minimum voltage to the maximum voltage and then decreased linearly, for the sake of convenience in explanation. When the entire output voltage to be generated by the hybrid switching amplifier 200 in each cycle based on the input signal and the result of the feedback control of the amplified signal has a value equal to or smaller than 500Vs, the output voltage is generated by the M inverters 232 to 238 sequentially operating to be switched ON. Thereafter, when generating the output voltage larger than 500Vs, one inverter among the N-1 inverters 222 to 228 is switched ON and the M inverters 232 to 238 are switched ON or OFF, to supply a desired output voltage. That is, when generating the output voltage of 650Vs, the first inverter having the lowest order among the N-1 inverters 222 to 228 is switched ON, and the first and second inverters having the lowest and second lowest orders among the M inverters 232 to 238 are switched ON in order to supply the rest of the output voltage, i.e.,150Vs. Thereafter, the first inverter having the lowest order among the M inverters 232 to 238 in ON state is switched OFF with the duty ratio of 50%, thus generating the output voltage of 650Vs.

In other words, the hybrid switching amplifier 200 according to some embodiments of the present disclosure causes the N-1 inverters 222 to 228 to supply most output voltage required to amplify the input signal while switching at a low switching frequency by way of the PWM control unit 205. At the same time, the hybrid switching amplifier 200 generates the PWM signal that allows the M inverters 232 to 238 to supply the rest of the output voltage while switching at a high switching frequency by way of the PWM control unit 205, thus achieving low conduction loss and low switching loss even at a high switching frequency.

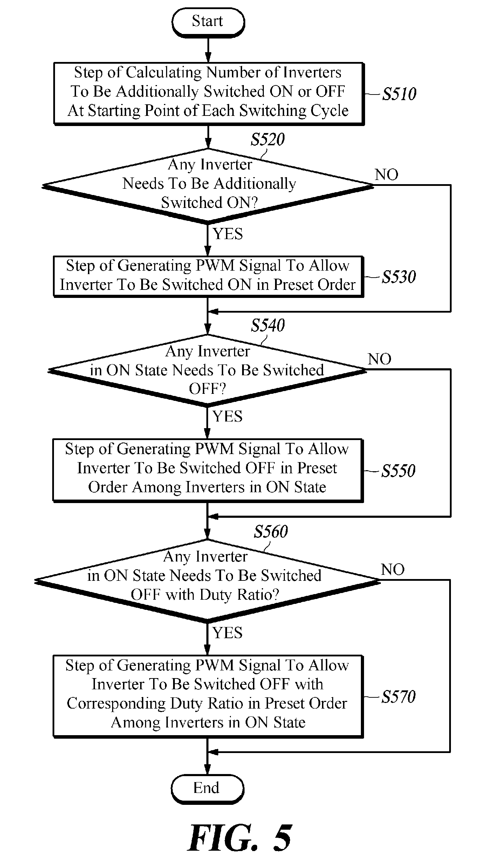

FIG. 5 is a flowchart of a method of generating the PWM signal for controlling the operations of the N inverters 112 to 118 by the fault-tolerant switching amplifier 100 according to some embodiments of the present disclosure.

As shown in FIG. 5, a method of generating the PWM signal for controlling operations of the N inverters 112 to 118 by the fault-tolerant switching amplifier 100 according to some embodiments of the present disclosure starts from a step of calculating the number of inverters to be additionally switched ON or OFF at a starting point of each switching cycle by the fault-tolerant switching amplifier 100 (step S510). That is, the fault-tolerant switching amplifier 100 determines an entire output voltage to be outputted from the N inverters 112 to 118 at the starting point of each switching cycle based on the input signal and the result of the feedback control of the amplified signal, and calculates the number of inverters to be additionally switched ON or OFF among the N inverters 112 to 118 based on the determined output voltage.

When there is an inverter to be additionally switched ON among the N inverters 112 to 118 (step S520), the fault-tolerant switching amplifier 100 generates the PWM signal that allows an inverter in the predetermined order to be additionally switched ON (step S530). For example, when there is an inverter to be additionally switched ON among the N inverters 112 to 118, the fault-tolerant switching amplifier 100 generates the PWM signal that allows the inverters to be additionally switched ON starting from an inverter having the highest order in the predetermined order.

When an inverter is to be switched OFF among the N inverters 112 to 118 (step S540), the fault-tolerant switching amplifier 100 generates the PWM signal that allows an inverter in the predetermined order among inverters in ON state to be switched OFF (step S550). For example, when there is an inverter to be switched OFF among the N inverters 112 to 118, the fault-tolerant switching amplifier 100 generates the PWM signal that allows the inverters to be switched OFF starting from an inverter having the lowest order among inverters in ON state.

When there is an inverter in ON state is to be switched OFF with a predetermined duty ratio among the N inverters 112 to 118 (step S560), the fault-tolerant switching amplifier 100 generates the PWM signal that allows an inverter in the predetermined order among inverters in ON state to be switched OFF with the predetermined duty ratio (step S570). For example, when an inverter in ON state is to be switched OFF with a predetermined duty ratio among the N inverters 112 to 118, the fault-tolerant switching amplifier 100 generates the PWM signal that allows an inverter having the lowest order in the predetermined order among inverters in ON state to be switched OFF with the predetermined duty ratio.

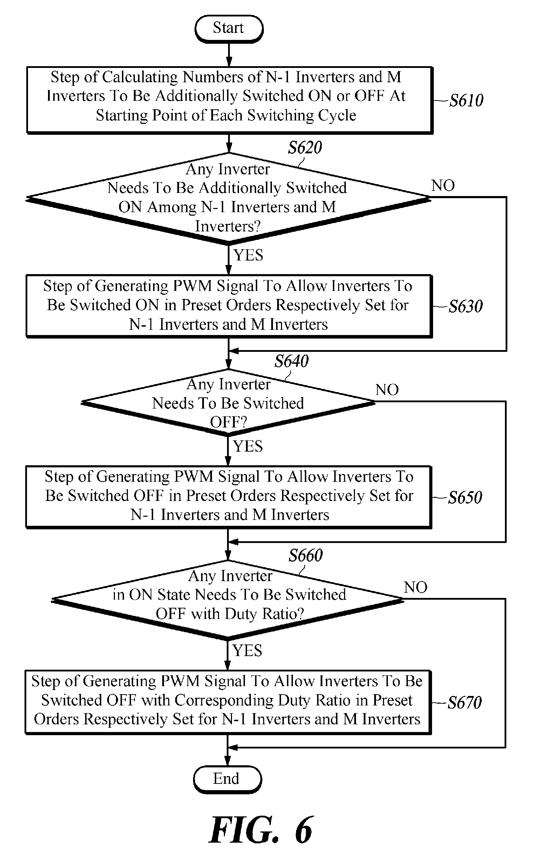

FIG. 6 is a flowchart of a method of generating the PWM signal for controlling the operations of the N-1 inverters 222 to 228 and the M inverters 232 to 238 by the hybrid switching amplifier 200 according to some embodiments of the present disclosure.

As shown in FIG. 6, a method of generating the PWM signal for controlling the operations of the N-1 inverters 222 to 228 and the M inverters 232 to 238 by the hybrid switching amplifier 200 according to some embodiments of the present disclosure starts from a step of determining the number of inverters to be additionally switched ON or OFF among the N-1 inverters 222 to 228 and the M inverters 232 to 238 at a starting point of each switching cycle by the hybrid switching amplifier 200 (step S610). That is, the hybrid switching amplifier 200 determines an entire output voltage to be outputted from the N-1 inverters 222 to 228 and the M inverters 232 to 238 at the starting point of each switching cycle based on the input signal and the result of the feedback control of the amplified signal. The hybrid switching amplifier 200 calculates the number of inverters to be additionally switched ON or OFF among the N-1 inverters 222 to 228 and the M inverters 232 to 238 based on the determined output voltage.

When there is at least one inverter to be additionally switched ON among the N-1 inverters 222 to 228 and the M inverters 232 to 238 (step S620), the hybrid switching amplifier 200 generates the PWM signal that allows the inverters in a preset order among the respective N-1 inverters 222 to 228 and M inverters 232 and 238 to be switched ON (step S630). For example, when at least one inverter is to be additionally switched ON among the N-1 inverters 222 to 228 and the M inverters 232 to 238, the hybrid switching amplifier 200 generates the PWM signal that allows the inverters to be additionally switched ON starting from an inverter having the highest order in a preset operation order among the respective N-1 inverters 222 to 228 and M inverters 232 to 238.

When there is at least one inverter in ON state to be switched OFF among the N-1 inverters 222 to 228 and the M inverters 232 to 238 (step S640), the hybrid switching amplifier 200 generates the PWM signal that renders the inverter to be switched OFF in a preset order among the respective N-1 inverters 222 to 228 and M inverters 232 to 238 (step S650). For example, when at least one inverter in ON state is to be switched OFF among the N-1 inverters 222 to 228 and the M inverters 232 to 238, the hybrid switching amplifier 200 generates the PWM signal that allows the inverters to be switched OFF starting from an inverter having the lowest order in the predetermined order among inverters in ON state.

When there is at least one inverter in ON state to be switched OFF with a predetermined duty ratio among the first to M-th inverters 222 to 228 and the (M+1)-th to N-th inverters 232 to 238 (step S660), the hybrid switching amplifier 200 generates the PWM signal that allows the inverters to be switched OFF with the predetermined duty ratio in a preset order among the respective N-1 inverters 222 to 228 and M inverters 232 to 238 (step S670). For example, when at least one inverter in ON state is to be switched OFF with a predetermined duty ratio among the N-1 inverters 222 to 228 and the M inverters 232 to 238, the hybrid switching amplifier 200 generates the PWM signal that allows an inverter having the lowest order among inverters in ON state to be switched OFF with the predetermined duty ratio.

Although steps S510 to S570 and steps S610 to S670 are described to be sequentially performed in the example shown in FIGs. 5 and 6, they merely instantiate technical ideas of some embodiments of the present disclosure. Therefore, a person having ordinary skill in the pertinent art could appreciate that various modifications, additions, and substitutions are possible by changing the sequences described in FIGs. 5 and 6 or by executing two or more steps from S510 to S570 and steps S610 to S670 in parallel, without departing from the gist and nature of the embodiments of the present disclosure, and hence FIGs. 5 and 6 are not limited to the illustrated chronological sequences.

Although exemplary embodiments of the present disclosure have been described for illustrative purposes, those skilled in the art will appreciate that various modifications, additions and substitutions are possible, without departing from the idea and scope of the claimed disclosure. Accordingly, one of ordinary skill would understand the scope of the claimed disclosure is not to be limited by the explicitly described above embodiments but by the claims and equivalents thereof.

### CROSS-REFERENCE TO RELATED APPLICATION

If applicable, this application claims priority under 35 U.S.C §119(a) of Patent Application No. 10-2013-0046340, filed on April 25, 2013 in Korea, the entire content of which is incorporated herein by reference. In addition, this non-provisional application claims priority in countries, other than the U.S., with the same reason based on the Korean patent application, the entire content of which is hereby incorporated by reference.

## Claims

1. A fault-tolerant switching amplifier, comprising:
an inverter unit including N inverters, where N is a natural number, each of the N inverters including a plurality of switching elements and configured to perform switching ON or OFF of the switching elements based on a PWM signal inputted to the switching elements, thus switching an applied direct-current (DC) voltage, and to generate an output signal based on the switching; and
a switch unit including N switches respectively connected to output terminals of the N inverters, each of the N switches being configured to be short-circuited or open-circuited based on whether or not the corresponding one of the N inverters is in a normal operation condition, wherein
the output terminals of the N inverters are connected in series, such that output signals outputted from the inverters are combined to generate an amplified signal.

2. The fault-tolerant switching amplifier according to claim 1, further comprising a PWM control unit configured to receive an input signal and to generate a PWM signal for determining a duty ratio based on the input signal.

3. The fault-tolerant switching amplifier according to claim 2, wherein the PWM control unit is configured to calculate number of inverters to be additionally switched ON or OFF at a starting point of each switching cycle based on the input signal and to generate the PWM signal that allows the N inverters to be switched ON or OFF in a preset order of the inverters.

4. The fault-tolerant switching amplifier according to claim 3, wherein the PWM control is configured to generate the PWM signal in a manner that,
when at least one inverter is to be additionally switched ON based on the input signal, the inverters are configured to be switched ON starting from an inverter having the highest order in the preset order,
when an inverter in ON state is to be switched OFF, the inverters are configured to be switched OFF starting from an inverter having the lowest order among the inverters in ON state in the preset order, and
when an inverter in ON state is to be switched OFF with a duty ratio, an inverter having the lowest order among the inverters in ON state is configured to be switched OFF with the duty ratio.

5. The fault-tolerant switching amplifier according to claim 1, wherein the inverter unit includes inverters of at least one more than the number of inverters required to achieve a predetermined maximum amplification level.

6. The fault-tolerant switching amplifier according to claim 5, wherein when there is an inverter that is not in the normal operation condition among the N inverters, the switch unit is configured to cause a switch corresponding to the inverter that is not in the normal operation condition to be short-circuited.

7. A hybrid switching amplifier, comprising:
an inverter unit comprising:
N-1 inverters, where N is a natural number larger than 1, each of the N-1 inverters including a plurality of first switching elements and M inverters, where M is a natural number, each of the M inverters including a plurality of second switching elements having electrical characteristics different from those of the N-1 inverters, the N-1 inverters and the M inverters being configured to perform switching ON or OFF of the first switching elements and the second switching elements, respectively, based on a PWM signal inputted to the first switching elements and the second switching elements, thus switching an applied direct-current (DC) voltage, and to generate an output signal based on the switching; and
a switch unit including N-1 switches and M switches respectively connected to output terminals of the N-1 inverters and the M inverters, each of the N-1 switches and the M switches being configured to be short-circuited or open-circuited based on whether or not the corresponding one of the N-1 inverters and M inverters is in a normal operation condition, wherein
the output terminals of the N-1 inverters and the M inverters are connected in series, such that output signals outputted from the inverters are combined to generate an amplified signal.

8. The hybrid switching amplifier according to claim 7, wherein
the first switching elements include switching elements having a withstand voltage and a switching loss higher than those of the second switching elements, and
the second switching elements includes switching elements having a withstand voltage and a switching loss lower than those of the first switching elements.

9. The hybrid switching amplifier according to claim 7, further comprising a PWM control unit configured to receive an input signal and to generate a PWM signal for determining a duty ratio based on the input signal.

10. The hybrid switching amplifier according to claim 9, wherein the PWM control unit is configured to generate the PWM signal that allows a switching frequency of the N-1 inverters to be lower than that of the M inverters, based on the input signal.

11. The hybrid switching amplifier according to claim 10, wherein the PWM control unit is configured to calculate the number of inverters from the N-1 inverters and the number of inverters from the M inverters to be additionally switched ON or OFF at a starting point of each switching cycle based on the input signal and to generate the PWM signal that allows the calculated number of inverters from the N-1 inverters the M inverters to be switched ON or OFF in a preset order among the respective N-1 inverters and M inverters.

12. The hybrid switching amplifier according to claim 11, wherein the PWM control is configured to generate the PWM signal in a manner that,
when at least one inverter is to be additionally switched ON from the N-1 inverters and the M inverters based on the input signal, the inverters are configured to be switched ON starting from an inverter having the highest order in the preset order,
when an inverter in ON state is to be switched OFF, the inverters are configured to be switched OFF starting from the inverter having the lowest order among the inverters in ON state in the preset order, and
when an inverter in ON state is to be switched OFF with a duty ratio, the inverter having the lowest order among the inverters in ON state is configured to be switched OFF with the duty ratio.

13. The hybrid switching amplifier according to claim 7, wherein the N-1 inverters and the M inverters respectively comprise inverters of at least one more than the inverters required to achieve a predetermined maximum amplification level.

14. The hybrid switching amplifier according to claim 13, wherein when there is an inverter that is not in the normal operation condition among the N-1 inverters or the M inverters, the switch unit is configured to cause a switch corresponding to the inverter that is not in the normal operation condition to be short-circuited.

15. A method performed by a fault-tolerant switching amplifier for generating a PWM signal for controlling operations of N inverters, the method comprising:
calculating the number of inverters to be additionally switched ON or OFF at a starting point of each switching cycle based on an input signal and a result of a feedback control of an amplified signal of the input signal;
generating, when an inverter is to be additionally switched ON from a result of the calculating, the PWM signal that allows an inverter in a predetermined order to be additionally switched ON;
generating, when an inverter is to be additionally switched OFF from a result of the calculating, the PWM signal that allows an inverter in a predetermined order among the inverters in ON state to be additionally switched OFF; and
generating, when an inverter is to be additionally switched OFF with a duty ratio from a result of the calculating, the PWM signal that allows an inverter in a predetermined order among the inverters in ON state to be additionally switched OFF with the duty ratio.

16. A method performed by a hybrid switching amplifier for generating a PWM signal for controlling operations of N-1 inverters and M converters, the method comprising:
calculating the number of inverters from the N-1 inverters and the number of inverters from the M inverters to be additionally switched ON or OFF at a starting point of each switching cycle based on an input signal and a result of a feedback control of an amplified signal of the input signal;
generating, when at least one inverter is to be additionally switched ON from the N-1 inverters and the M inverters from a result of the calculating, the PWM signal that allows the inverters in a preset order among the respective N-1 inverters and M inverters to be additionally switched ON;
generating, when at least one inverter in ON state is to be additionally switched OFF from the N-1 inverters and the M inverters from a result of the calculating, the PWM signal that allows the inverters in a preset order among the respective N-1 inverters and M inverters to be additionally switched OFF; and
generating, when at least one inverter in ON state is to be additionally switched OFF with a duty ratio from the N-1 inverters and the M inverters from a result of the calculating, the PWM signal that allows the inverters in a preset order among the respective N-1 inverters and M inverters to be additionally switched OFF with the duty ratio.
